(19) Europäisches Patentamt
European Patent Office
Office européen des brevets

(11) **EP 3 584 834 A1**

(12) **EUROPEAN PATENT APPLICATION**
published in accordance with Art. 153(4) EPC

(43) Date of publication:
25.12.2019 Bulletin 2019/52

(51) Int Cl.:
*H01L 25/07* (2006.01)        *H01L 23/29* (2006.01)
*H01L 25/18* (2006.01)

(21) Application number: 18754582.7

(22) Date of filing: 08.02.2018

(86) International application number:
PCT/JP2018/004428

(87) International publication number:
WO 2018/151010 (23.08.2018 Gazette 2018/34)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD TN

(30) Priority: 15.02.2017 JP 2017026218

(71) Applicants:
• Kabushiki Kaisha Toshiba
Minato-ku
Tokyo 105-8001 (JP)
• Toshiba Energy Systems & Solutions
Corporation
Kawasaki-shi, Kanagawa 212-0013 (JP)

(72) Inventors:
• ICHIKURA, Yuta
Tokyo 1050023 (JP)
• ITO, Hiroaki
Tokyo 1050023 (JP)

• OHBU, Toshiharu
Tokyo 1050023 (JP)
• TAKIMOTO, Kazuyasu
Tokyo 1050023 (JP)
• YAMANARI, Naoki
Tokyo 1050023 (JP)
• WATANABE, Naotake
Tokyo 1050023 (JP)
• SEKIYA, Hiroki
Kawasaki-shi,
Kanagawa 2120013 (JP)
• HISAZATO, Yuuji
Kawasaki-shi,
Kanagawa 2120013 (JP)
• IIO, Naotaka
Kawasaki-shi,
Kanagawa 2120013 (JP)
• MATSUMURA, Hitoshi
Tokyo 1050023 (JP)

(74) Representative: Henkel & Partner mbB
Patentanwaltskanzlei, Rechtsanwaltskanzlei
Maximiliansplatz 21
80333 München (DE)

(54) **SEMICONDUCTOR DEVICE**

(57) A semiconductor device includes a first metal plate having a first surface, a second metal plate having a second surface facing the first surface, and two or more semiconductor modules disposed between the first metal plate and the second metal plate. The two or more semiconductor modules each include a first metal member electrically connected to the first metal plate, a second metal member electrically connected to the second metal plate, at least one semiconductor element disposed between the first metal member and the second metal member, and a resin member for sealing the semiconductor element between the first metal member and the second metal member. The at least one semiconductor element has a first electrode electrically connected to the first metal member and a second electrode electrically connected to the second metal member.

EP 3 584 834 A1

FIG. 1

## Description

[FIELD]

Embodiments relate to a semiconductor device.

[BACKGROUND]

A semiconductor device used for a megawatt class power converter or the like, which has a breakdown voltage of several kilovolts (kV), is required to have a large current capacity. In such applications, it is suitable for the semiconductor device to have a structure in which a plurality of semiconductor elements are mounted in parallel. However, the high accuracy of processing is required for the semiconductor device, in which all the semiconductor elements mounted in parallel operate uniformly, resulting in the increased manufacturing cost thereof.

[Prior Arts]

[Patent documents]

[Patent document 1] Japanese Unexamined Patent Application Publication No. H8-330338
[Patent document 2] Japanese Unexamined Patent Application Publication No. 2006-13080

[Summary of Inventions]

[Issues to be solved]

Embodiments provide a semiconductor device having the large current capacity at low cost.

[Means for solving the Issues]

According to an embodiment, a semiconductor device includes a first metal plate having a first surface, a second metal plate having a second surface facing the first surface, and two or more semiconductor modules disposed between the first metal plate and the second metal plate. Each of the two or more semiconductor modules includes a first metal member electrically connected to the first metal plate, a second metal member electrically connected to the second metal plate, at least one semiconductor element disposed between the first metal member and the second metal member, and a resin member sealing the semiconductor element between the first metal member and the second metal member. The at least one semiconductor element has a first electrode electrically connected to the first metal member and a second electrode electrically connected to the second metal member.

[Brief description of the Drawings]

FIG. 1 is a schematic cross-sectional view showing a semiconductor device according to a first embodiment;
FIG. 2 is a schematic cross-sectional view showing a semiconductor module according to the first embodiment;
FIG. 3 is a schematic view showing another cross section of the semiconductor device according to the first embodiment;
FIG. 4 is a graph showing a characteristic of the semiconductor device according to the first embodiment;
FIG. 5 is a schematic cross-sectional view showing a semiconductor device according to a first variation of the first embodiment;
FIG. 6 is a schematic cross-sectional view showing a semiconductor device according to a second variation of the first embodiment;
FIG. 7 is a schematic cross-sectional view showing a semiconductor device according to a third variation of the first embodiment;
FIG. 8 is a schematic cross-sectional view showing a semiconductor device according to the fourth variation of the first embodiment;
FIG. 9 is a cross-sectional view schematically showing a semiconductor device according to a fifth variation of the first embodiment;
FIG. 10 is a perspective view schematically showing a semiconductor module according to the sixth variation of the first embodiment;
FIG. 11 is a perspective view schematically showing a semiconductor module according to the seventh variation of the first embodiment;
FIG. 12 is a schematic cross-sectional view showing the semiconductor module according to the eighth variation of a first embodiment;
FIG. 13 is a schematic cross-sectional view showing a semiconductor device according to a second embodiment;
FIGS. 14A and 14B are schematic views showing a semiconductor module according to the second embodiment;
FIGS. 15A and 15B are schematic views showing parts of the semiconductor module according to the second embodiment;
FIG. 16 is a schematic view showing the semiconductor module according to the second embodiment;
FIGS. 17A and 17B are schematic cross-sectional views showing another semiconductor module according to the second embodiment;
FIG. 18 is a schematic plan view showing the semiconductor device according to the second embodiment;
FIG. 19 is a schematic cross-sectional view showing a semiconductor device according to a first variation of the second embodiment;

FIG. 20 is a schematic cross-sectional view showing a semiconductor device according to a second variation of the second embodiment;

FIG. 21 is a schematic cross-sectional view showing a semiconductor device according to a third embodiment;

FIG. 22 is a schematic plan view showing the semiconductor device according to the third embodiment;

FIG. 23 is a schematic plan view showing another semiconductor device according to the third embodiment;

FIG. 24 is a schematic plan view showing a semiconductor device according to a variation of the third embodiment;

FIGS. 25A and 25B are schematic views showing a semiconductor device according to a fourth embodiment;

FIGS. 26A and 26B are schematic views showing parts of the semiconductor device according to the fourth embodiment;

FIG. 27 is a perspective view schematically showing a signal line of the semiconductor device according to the fourth embodiment;

FIGS. 28A and 28B are views showing a semiconductor device according to a first variation of the fourth embodiment; and

FIG. 29 is a schematic cross-sectional view showing a semiconductor device according to a second variation of the fourth embodiment.

[Detailed description]

Embodiments will now be described with reference to the drawings. The same portions inside the drawings are marked with the same numerals; a detailed description is omitted as appropriate; and the different portions are described. The drawings are schematic or conceptual; and the relationships between the thicknesses and widths of portions, the proportions of sizes between portions, etc., are not necessarily the same as the actual values thereof. The dimensions and/or the proportions may be illustrated differently between the drawings, even in the case where the same portion is illustrated.

There are cases where the dispositions of the components are described using the directions of XYZ axes shown in the drawings. The X-axis, the Y-axis, and the Z-axis are orthogonal to each other. Hereinbelow, the directions of the X-axis, the Y-axis, and the Z-axis are described as an X-direction, a Y-direction, and a Z-direction. Also, there are cases where the Z-direction is described as upward and the direction opposite to the Z-direction is described as downward.

(First Embodiment)

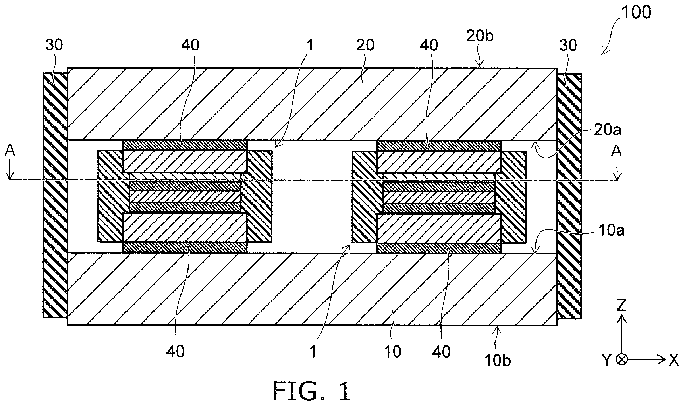

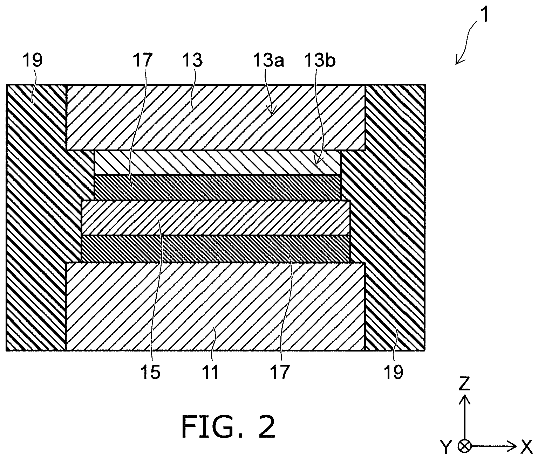

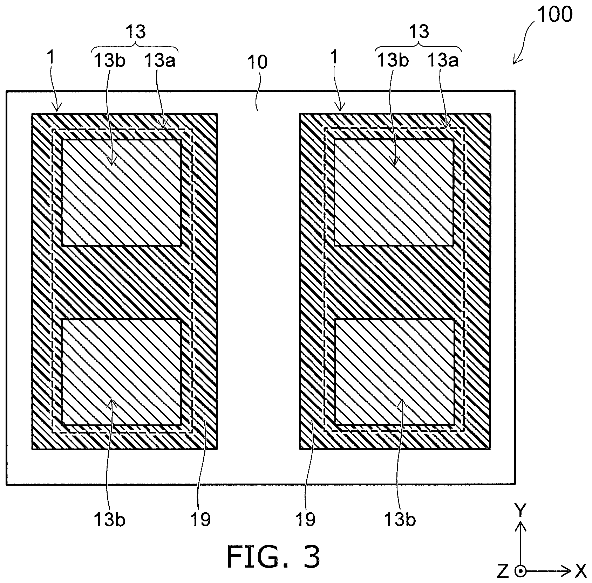

FIG. 1 is a schematic cross-sectional view showing a semiconductor device 100 according to a first embodiment. The semiconductor device 100 is, for example, a large current type semiconductor device, and includes a plurality of semiconductor modules 1. FIG. 2 is a schematic cross-sectional view showing a semiconductor module 1. FIG. 3 is a schematic cross-sectional view taken along the line A-A shown in FIG.1.

As shown in FIG. 1, the semiconductor device 100 includes a metal plate 10, a metal plate 20, and two or more semiconductor modules 1. The metal plate 10 has a major surface 10a and a major surface 10b opposite to the major surface 10a. The metal plate 20 has a major surface 20a facing the major surface 10a of the metal plate 10, and a major surface 20b on a side opposite thereto. The semiconductor module 1 is disposed between the metal plate 10 and the metal plate 20. The metal plates 10 and 20 are electrically connected to semiconductor module 1 via bonding members 40, respectively. The bonding members 40 are, for example, conductive adhesive such as metal solder, silver paste or the like.

Moreover, a case 30 is attached to the side surfaces of the metal plates 10 and 20, and seals a space between the metal plate 10 and the metal plate 20. In the space between the metal plate 10 and the metal plate 20, for example, a space between the semiconductor modules 1 is filled with an insulating gas such as SF6 or a gel-like insulating member.

As shown in FIG. 2, the semiconductor module 1 includes a metal member 11, a metal member 13, a semiconductor element 15, and a sealing resin 19. The semiconductor element 15 is disposed between the metal member 11 and the metal member 13. The metal members 11 and 13 are, for example, electrode plates, for which material superior in electrical conductivity and thermal conductivity such as copper and like is used. For example, the metal members 11 and 13 are made of the same material. Alternately, it is possible for the metal member 11 and the metal member 13 to be made of materials different in the linear expansion coefficient from each other in order to reduce the thermal strain due to the different shapes thereof.

The semiconductor element 15 is sealed between the metal members 11 and 13 using a sealing resin 19. For example, the sealing resin 19 is injected into a mold for resin molding under vacuum condition, and is solidified. Thereby, it is possible to seal without leaving air bubbles in the vicinity of the metal members 11, 13 and the semiconductor element 15. The sealing resin 19 is, for example, a thermosetting resin such as a melamine-based resin or the like.

The semiconductor element 15 is a power semiconductor chip, and is, for example, a switching element such as an IGBT (Insulated Gate Bipolar Transistor) or a MOSFET (Metal-Oxide-Semiconductor Field-Effect Transistor) which has a control electrode. The semiconductor element 15 may be a diode such as a fast recovery diode (FRD). It is not necessary for all of the semiconductor modules 1 provided in the semiconductor device 100 to include the same type of semiconductor element 15, and the semiconductor module 1 may have a mixed configuration of a switching element such as the IGBT or the like and a diode such as the FRD or the like.

The semiconductor device 15 has a collector electrode (or a drain electrode or an anode electrode) and an emitter electrode (or a source electrode or a cathode electrode). The metal member 11 is electrically connected to the semiconductor element 15, for example, on the collector electrode side via a bonding member 17. The metal member 13 is electrically connected to the semiconductor element 15, for example, on the emitter electrode side via a bonding member 17. The bonding member 17 is, for example, conductive adhesive such as metal solder, silver paste or the like.

The metal member 13 includes a first portion 13a and a second portion 13b. The second portion 13b is disposed between the first portion 13a and the semiconductor element 15. The semiconductor element 15 is connected to the second portion 13b via the bonding member 17.

It is preferable for the bonding member 17 to use a material having a melting point higher than that of the bonding member 40. For example, the solder made of tin and silver as raw materials and having a melting point of about 220 degrees Celsius is used for the bonding member 17. The solder made of tin, silver and copper as raw materials and having a melting point of about 200 degrees Celsius is used for the bonding member 40.

When remelting of the bonding member 17 occurs inside the semiconductor module 1 in the process of soldering the semiconductor module 1 to the metal plate 10 and the metal plate 20, for example, there may be a crack generated in the sealing resin 19, causing a failure due to the outflow of the bonding member 17. According to the embodiment, when heating the bonding member 40 to solder the semiconductor module 1, the bonding member 17 can be maintained at the temperature under the melting point or less. It is possible to solder the semiconductor module 1 by melting the bonding member 40 while preventing the bonding member 17 from melting, thereby improving the reliability of the semiconductor module 1.

As shown in FIG. 3, in the metal member 13, the second portion 13b has the cross-sectional area parallel to the X-Y plane smaller than the cross-sectional area of the first portion 13a parallel to the X-Y plane. The metal member 13 has, for example, one first portion 13a and two second portions 13b. Then, the semiconductor element 15 is connected to each of the two second portions 13b. The metal member 13 is not limited to this example, and may include one second portion 13b or three or more second portions 13b.

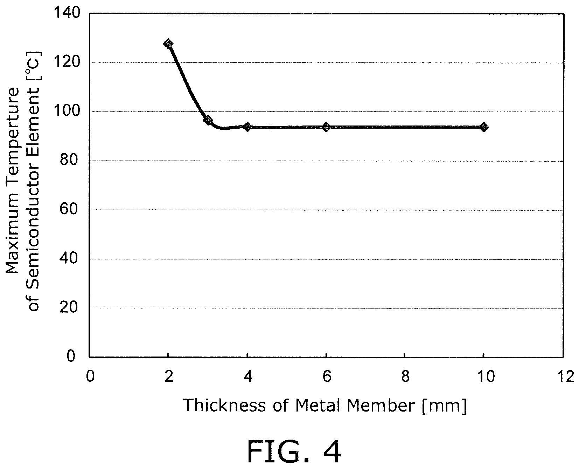

FIG. 4 is a graph showing the characteristic of the semiconductor device 100 when a pulse current is supplied thereto. The vertical axis represents the temperature (degrees Celsius) of the semiconductor element 15, and the horizontal axis represents the thickness (mm) of the metal members 11 and 13.

As shown in FIG. 4, the temperature of the semiconductor element 15 decreases as the thickness of the metal members 11 and 13 increases. When the thickness of the metal members 11 and 13 is 3 mm or more, the temperature of the semiconductor element 15 becomes constant. That is, when the thickness of the metal members 11 and 13 is 3 mm or more, the metal members 11 and 13 function as a heat sink and absorb the heat of the semiconductor element 15. On the other hand, when the thickness of the metal members 11 and 13 is 3 mm or less, the temperature of the semiconductor element 15 is raised due to the small heat capacity of the metal members 11 and 13 as compared to the heat amount generated in the semiconductor element 15. Accordingly, the metal members 11 and 13 have the thickness of preferably 3 mm or more. Here, the thickness of the metal member 13 is the sum of the thickness of the first portion 13a and the thickness of the second portion 13b.

The operation and advantages of the embodiment will be described as follows. For example, the large current type semiconductor device can be manufactured by arranging a plurality of semiconductor elements 15 on an electrode plate and pressure-contacting collectively. However, it is difficult to press each semiconductor element 15 evenly. Alternatively, it is possible to improve the reliability of bonding by soldering both surfaces of the semiconductor element 15. However, when soldering a large number of semiconductor elements at once, there may be a bonding defect due to the processing accuracy of the metal member and the temperature variations while raising the temperature. Moreover, the semiconductor device is defective, when the bonding failure exists in at least one semiconductor element, then deteriorating the manufacturing yield.

In contrast, the semiconductor device 100 according to the embodiment uses the semiconductor module 1 that includes the semiconductor element 15 soldered in one or more small units between the metal members 11 and 13. Then, the semiconductor device 100 is manufactured by providing a plurality of semiconductor modules 1 mounted in a planar arrangement between the metal plates 10 and 20. Thereby, it is possible to conduct an electrical test for each semiconductor module 1 and to improve the manufacturing yield of the semiconductor device 100 by using only the non-defective modules. Moreover, the large current capacity in the semiconductor device 100 can be easily achieved by increasing the number of semiconductor modules 1.

Moreover, as shown in FIG. 4, it is possible to suppress the temperature rise in the semiconductor element 15 by making the metal members 11 and 13 have the thickness of 4 mm or more. Thereby, melting and vaporizing of the members can be reduced when a large current takes place due to the failure. For example, it is possible to prevent the case 30 from rupturing. Thus, it is possible to improve the reliability of the semiconductor device 100.

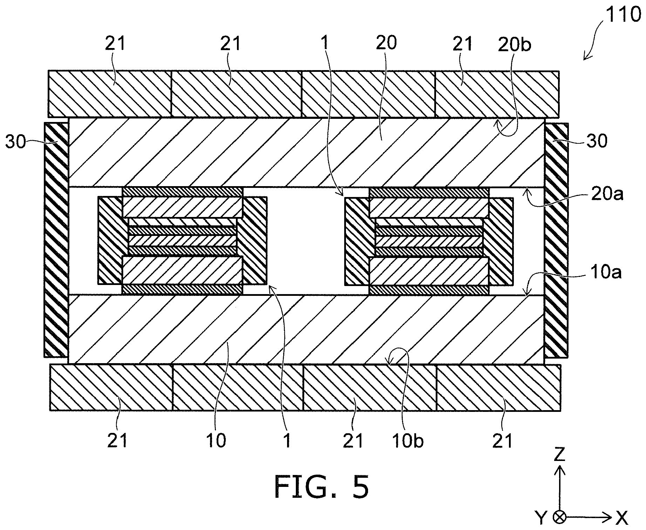

FIG. 5 is a schematic cross-sectional view showing a semiconductor device 110 according to a first variation of the first embodiment. In this example, heat sinks 21 are provided, which are in contact with the metal plates 10 and 20. For example, the semiconductor module 1 is provided on the major surface 10a of the metal plate 10. A heat sink 21 is disposed to be in contact with the major surface 10b opposite to the major surface 10a. The semiconductor module 1 is provided on the major surface 20a side of the metal plate 20, and another heat sink 21 is disposed to be in contact with the major surface 20b opposite to the major surface 20a. Moreover, a plurality of heat sinks 21 are disposed on each of the metal plates 10 and 20.

The heat sinks 21 are bonded to the metal plates 10 and 20 using, for example, soldering, brazing, or friction stir welding (FSW). The heat sinks 21 are electrically and thermally connected to the metal plates 10 and 20. For example, material superior in thermal conductivity and electrical conductivity such as copper and aluminum is used for the heat sinks 21.

The metal plates 10 and 20 are enlarged in the semiconductor device 100 in which a plurality of semiconductor modules 1 are mounted. Thus, when bonding a heat sink of one body to each of the metal plates 10 and 20, high accuracy is required for planarization processes of bonding surfaces of the metal plate 10, 20 and the heat sink, resulting in raising the manufacturing cost. In contrast, by using the plurality of heat sinks 21, the planarization of each bonding surface becomes easy, thereby improving the productivity and reducing the manufacturing cost. Moreover, the heat sinks 21 each have small heat capacity as compared with the heat sink of one body. When bonding the heat sinks 21 to the metal plates 10 and 20 by soldering, it is possible to suppress the temperature variations while raising the temperature, thus reducing the bonding defect in the heat sinks 21.

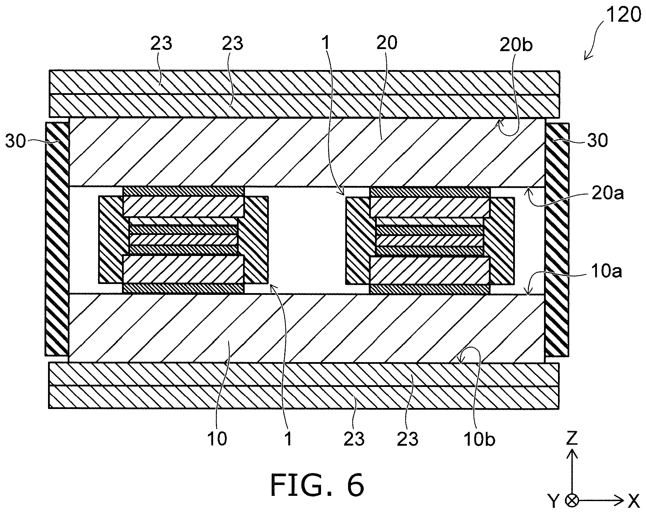

FIG. 6 is a schematic cross-sectional view showing a semiconductor device 120 according to a second variation of the first embodiment. In this example, heat sinks 23 are provided to be in contact with the metal plates 10 and 20, respectively. The embodiment is different from the above-described embodiment in that the heat sink is divided horizontally into a plurality of parts. In each heat sink, the divided size and shape may be different from each other.

Heat sinks 23 are stacked on the major surface 10b of the metal plate 10. Also, other heat sinks 23 are stacked on the major surface 20b of the metal plate 20. Thus, it is possible to reduce the heat capacity of each heat sink 23 by thinning the thickness thereof.

The heat sinks 23 are sequentially bonded using, for example, soldering. When the heat capacity of the heat sink 23 is small, it is possible to shorten the times required for the temperature rising and cooling. Moreover, it is possible to miniaturize a heater or the like for raising the temperature of the heat sink 23. That is, bonding the heat sinks 23 can be easily performed by shortening the time required for the bonding. Moreover, when the heat sinks 23 are soldered, it is possible to suppress the temperature variations when raising the temperature. Thereby, it is possible to improve the processability and productivity by reducing the bonding failure of the heat sinks 23.

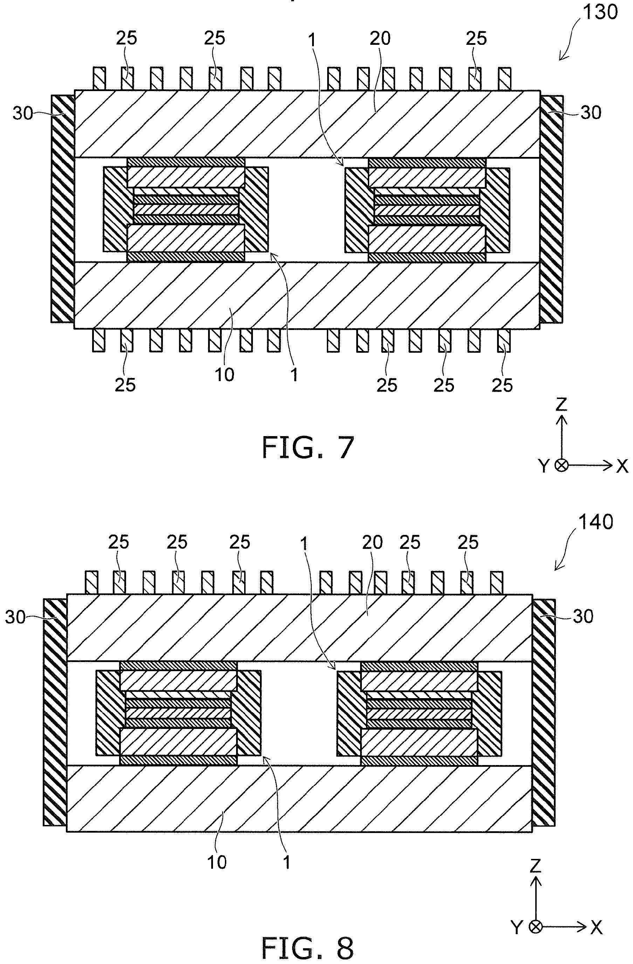

FIG. 7 and FIG. 8 are schematic cross-sectional views showing semiconductor devices 130 and 140 according to third and fourth variations of the first embodiment, respectively. As shown in FIG. 7, a plurality of heat radiating fins 25 are attached to the metal plates 10 and 20, and the metal plates 10 and 20 and the heat sink are integrated. The heat radiating fins 25 can be bonded to the metal plates 10 and 20 using, for example, friction stir welding or the like. Alternatively, the heat radiating fins 25 may be provided on either one of the metal plates 10 and 20 as shown in FIG. 8.

As described above, by directly attaching the heat radiating fins to the metal plates 10 and 20, it is possible to omit the bonding process of heat sinks to the metal plates 10 and 20 and the application process of heat conduction grease. The cost reduction can be achieved by reducing the number of heat-sink members. Moreover, omitting the application of the heat conductive grease makes it possible to prevent the compound from dropping out and to reduce the thermal resistance.

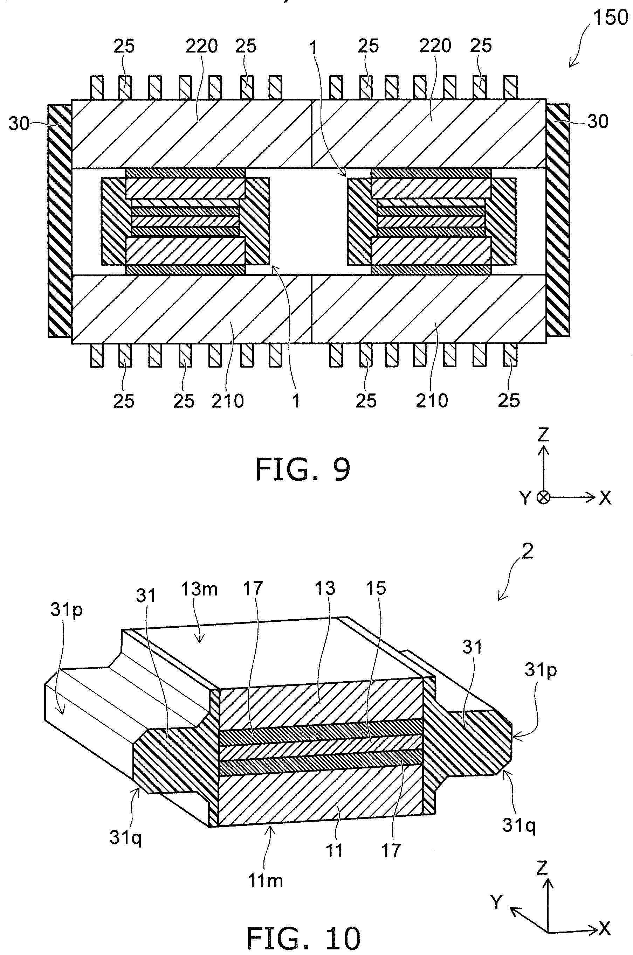

FIG. 9 is a schematic cross-sectional view showing a semiconductor device 150 according to a fifth variation of the first embodiment. In this example, metal plates 210 and 220 are provided in place of the metal plates 10 and 20. In other words, metal plates 10 and 20 are divided into a plurality. The metal plates 210 and 220 are miniaturized as compared with the metal plates 10 and 20.

For example, at least one semiconductor module 1 is disposed between a pair of metal plates 210 and 220. The metal plates 210 and 220 each are connected in the X direction and the Y direction. In this example, by miniaturizing the metal plates 210 and 220, it is possible to improve the accuracy of flatness and like in the major surfaces thereof. Thereby, the productivity of the semiconductor device 150 can be improved.

FIG. 10 is a perspective view schematically showing a semiconductor module 2 according to a sixth variation of the first embodiment. The semiconductor module 2 includes metal members 11 and 13, a semiconductor element 15, and a sealing resin 31. The semiconductor element 15 is disposed between the metal members 11 and 13 and is electrically connected to the metal members 11 and 13 via bonding members 17. The sealing resin 31 is attached to the side surfaces of the metal members 11 and 13, and seals the semiconductor element 15 between the metal members 11 and 13. The sealing resin 31 is, for example, a thermosetting resin such as a melamine resin and like.

The sealing resin 31 is provided so that the major surface 11m of the metal member 11 and the major surface 13m of the metal member 13 are exposed at the bottom surface and the top surface of the semiconductor module 2, respectively. In addition, the sealing resin 31 has a convex portion 31p that protrudes in the lateral directions (for example, the X direction and the Y direction). The convex portion 31p has the shape in which chamfers are provided at the corners 31q of the tip. The convex portion 31p is provided, for example, by integral molding using a mold.

Further, the sealing resin 31 covering the side surfaces of the metal members 11 and 13 is required to have a creepage distance corresponding to the breakdown voltage of the semiconductor element 15. For example, when the breakdown voltage of the semiconductor element 15 is 4.5 kV, the creepage distance is desired to be 20 mm or more from the major surface 11m of the metal member 11 to the major surface 13m of the metal member 13 along the surface of the sealing resin 31.

However, it is difficult to set the distance between the major surface 11m and the major surface 13m to 20 mm or more. For example, the thickness of each of the metal members 11 and 13 is preferably 3 mm or more. Moreover, the thicknesses of the metal members 11 and 13 are desirably set to as thin as possible to reduce the thermal resistance. Thus, the distance between the major surface 11m and the major surface 13m is about 10 mm, although including the thicknesses of the semiconductor element 15 and the bonding members. Accordingly, it is preferable to extend the creepage distance by providing the convex portion 31p of the sealing resin 31. For example, the creepage distance of 20 mm or more can be achieved from the major surface 11m to the major surface 13m by providing the convex portion 31p protruding by 6 mm in the lateral direction.

Thus, the semiconductor module 2 can be downsized while extending the creepage distance of the sealing resin 31 by providing the convex portion 31p. Moreover, it becomes easy to remove the mold for the resin sealing by providing the chamfers at the corners 31q of the convex portion 31p, and workability thereof is improved.

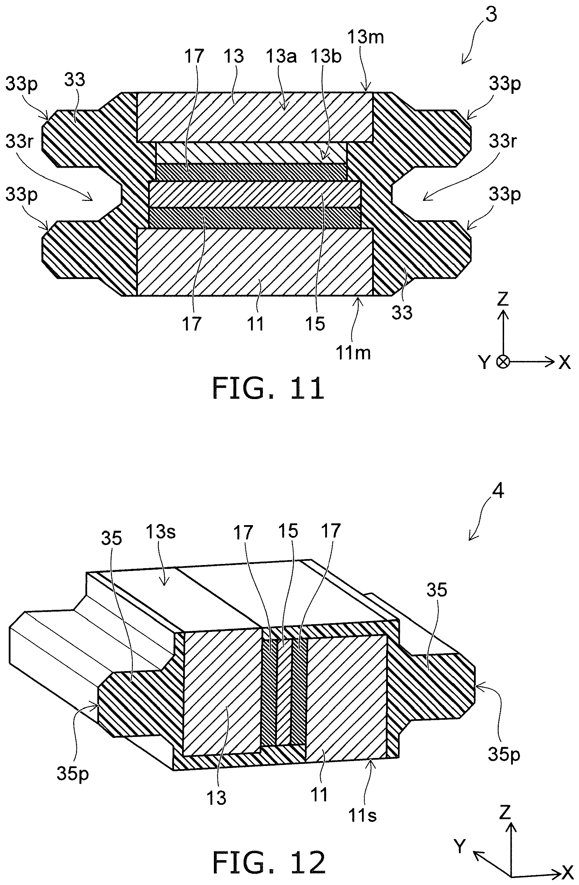

FIG. 11 is a cross-sectional view schematically showing a semiconductor module 3 according to a seventh variation of the first embodiment. The semiconductor module 3 includes metal members 11 and 13, a semiconductor element 15, and a sealing resin 33.

As shown in FIG. 11, the sealing resin 33 has two convex portions 33p protruding in the lateral direction. In other words, the sealing resin 33 has the recessed potion 33r that is receded in the lateral direction. Thereby, the creepage distance from the major surface 11m of the metal member 11 to the major surface 13m of the metal member 13 can be further extended. Moreover, embodiment is not limited to this example. For example, any number of the convex parts 33p (or the recessed part 33r) may be provided in the sealing resin 33.

FIG. 12 is a perspective view schematically showing a semiconductor module 4 according to an eighth variation of the first embodiment. The semiconductor module 4 includes metal members 11 and 13, a semiconductor element 15, and a sealing resin 35. In this example, the semiconductor element 15 is positioned between the metal member 11 and the metal member 13 which are arranged in the lateral direction. The sealing resin 35 includes a portion extending over the top or bottom surface of the semiconductor module 4, and seals the semiconductor element 15. Moreover, the sealing resin 35 has a convex portion 35p that protrudes in the lateral direction. Then, the side surface 11s of the metal member 11 and the side surface 13s of the metal member 13 are exposed at the bottom surface and the top surface of the semiconductor module 4, respectively.

As described above, the semiconductor element 15 may have the major surfaces arranged, for example, in the direction crossing the X direction. Thereby, it is possible to mitigate the stress applied to the semiconductor element 15 when molding the sealing resin 35, and to avoid the characteristic deterioration or breakage thereof.

(Second Embodiment)

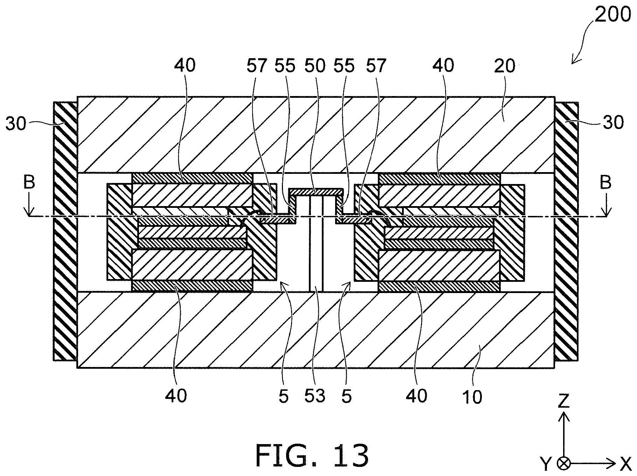

FIG. 13 is a schematic cross-sectional view showing a semiconductor device 200 according to the second embodiment. As shown in FIG. 13, the semiconductor device 200 includes a metal plate 10, a metal plate 20, semiconductor modules 5, and a signal line 50. The semiconductor modules 5 and the signal line 50 are disposed between the metal plate 10 and the metal plate 20. The metal plates 10 and 20 each are electrically connected to the semiconductor modules 5 via bonding members 40. Between the metal plates 10 and 20, the signal line 50 is disposed between the adjacent semiconductor modules 5. The signal line 50 is fixed, for example, to the metal plate 10 via an insulating spacer 53.

As shown in FIG. 13, the semiconductor modules 5 each have a gate terminal 57 electrically connected to the gate electrode of the semiconductor element 15. The gate terminal 57 is electrically connected to the signal line 50 by the connection conductor 55. For example, material superior in the electrical conductivity such as copper is used for the gate terminal 57.

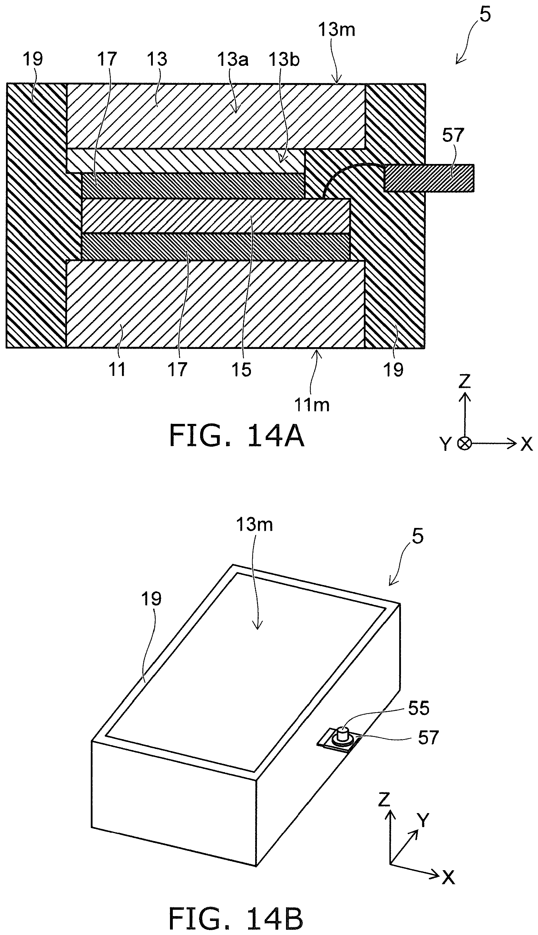

FIGS. 14A and 14B are schematic views showing a semiconductor module 5. FIG. 14A is a cross-sectional view showing the semiconductor module 5, and FIG. 14B is a perspective view showing the appearance of the semiconductor module 5.

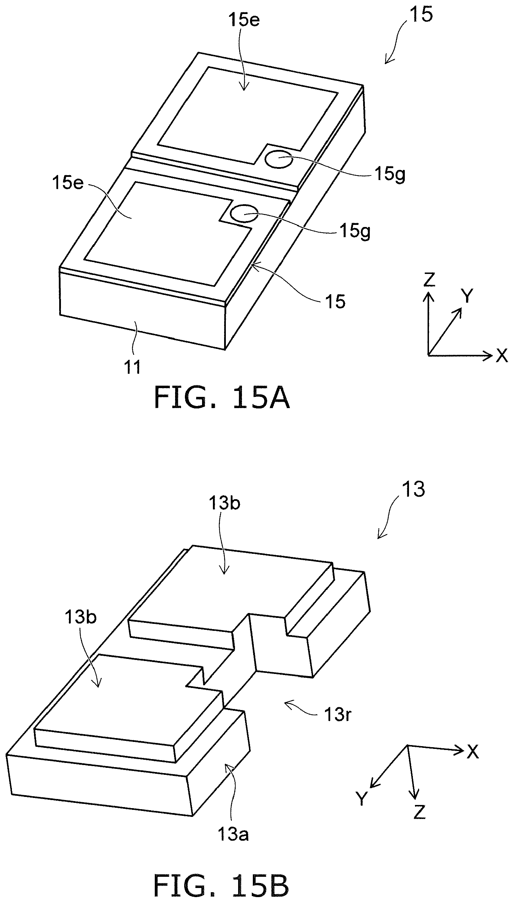

As shown in FIG. 14A, the semiconductor module 5 includes a metal member 11, a metal member 13, a semiconductor element 15, a sealing resin 19, and a gate terminal 57. The semiconductor element 15 is disposed between the metal member 11 and the metal member 13. The gate terminal 57 is fixed to the sealing resin 19. The gate terminal 57 is electrically connected to, for example, the gate electrode of the semiconductor element 15 (see FIG. 15B) through a metal wire 59.

As shown in FIG. 14B, the sealing resin 19 is provided so as to surround the side surface of the semiconductor module 5. The gate terminal 57 is provided so as to protrude laterally from the sealing resin 19. Further, the major surface 13m of the metal member 13 is exposed at the top surface of the semiconductor module 5. On the other hand, the major surface 11m of the metal member 11 is exposed at the bottom surface (not shown).

As described above, by making the gate terminal 57 protrude from the semiconductor module 5, the test apparatus can be connected to the gate terminal 57 and apply a voltage to the gate electrode 15g of the semiconductor element 15. Moreover, the electrical test of the semiconductor module 1 can be performed by applying a voltage to the metal members 11 and 13 exposed at the bottom surface and the top surface of the semiconductor module 5.

FIG. 15A and 15B are perspective views schematically showing the structure of the semiconductor module 5. FIG. 15A is a perspective view showing the semiconductor elements 15 mounted on the metal member 11. FIG. 15B is a perspective view showing the metal member 13.

As shown in FIG. 15A, for example, two semiconductor elements 15 are mounted on the metal member 11. A semiconductor element 15 has, for example, an emitter electrode 15e and a gate electrode 15g on the surface thereof. The gate electrode 15g is electrically connected to the gate terminal 57, for example, via the metal wire 59. The semiconductor element 15 also has a collector electrode on the back surface (not shown), and the metal member 11 is electrically connected to the collector electrode through the bonding member 17.

As shown in FIG. 15B, the metal member 13 includes a first portion 13a and a second portion 13b. Moreover, the metal member 13 has a recess 13r. The second portion 13b is electrically connected to the emitter electrode 15e via the bonding member 17. The recess 13r is provided to remove a portion overlapping the gate electrode 15g. That is, the recess 13r is provided so that the gate electrode 15g is exposed when the metal member 13 is stacked on the semiconductor elements 15 shown in FIG.15A.

As shown in FIG. 15B, the second portion 13b is provided to fit the shape of the emitter electrode 15e. The surface of the second portion 13b, for example, has substantially the same shape as or is similar in shape to the emitter electrode 15e.

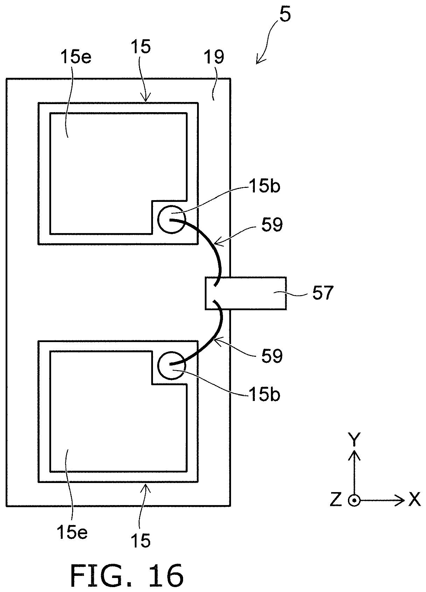

FIG. 16 is a schematic plan view illustrating the electrical connection between the semiconductor element 15 and the gate terminal 57. As shown in FIG. 16, gate electrodes 15 g of two semiconductor elements 15 are electrically connected to one gate terminal 57 via metal wires 59 respectively. Then, it is preferable to connect the semiconductor elements 15 and the gate terminal 57 so that the metal wires 59 have substantially the same length.

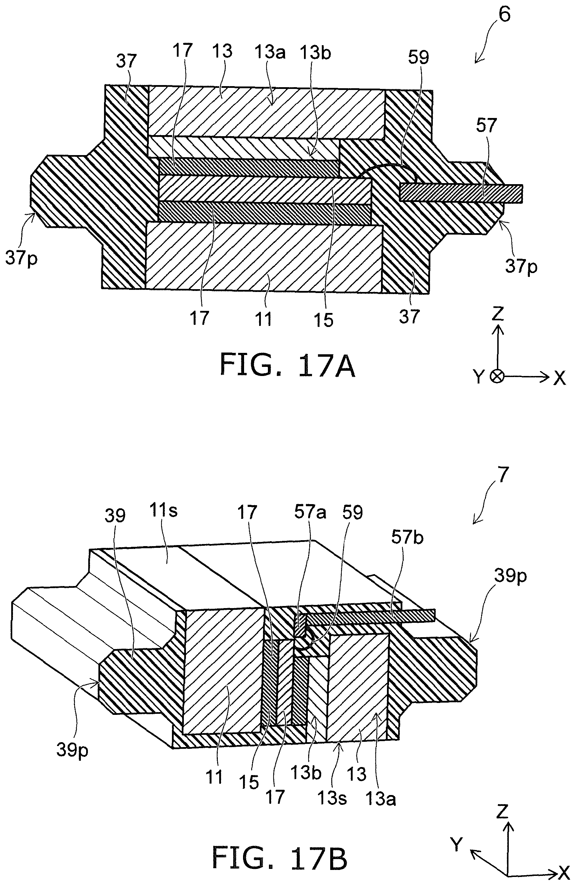

FIG. 17A and 17B are schematic views showing other semiconductor modules 6 and 7 according to the second embodiment. FIG. 17A is a cross-sectional view showing the semiconductor module 6. FIG. 17B is a perspective view showing the semiconductor module 7.

As shown in FIG. 17A, the semiconductor module 6 includes the metal members 11 and 13 arranged in the Z direction, and the semiconductor element 15 disposed therebetween. The sealing resin 37 for sealing the semiconductor element 15 between the metal members 11 and 13 has a convex portion 37p protruding in the lateral direction. The gate terminal 57, for example, is provided so as to protrude toward the outside from the tip of the convex portion 37p.

As shown in FIG. 17B, the semiconductor module 7 has the metal members 11 and 13 arranged in the X direction and the semiconductor element 15 disposed therebetween. Then, the sealing resin 39 has a portion extending over the top surface side or the bottom surface side of the semiconductor module 7 and seals the semiconductor element 15 between the metal members 11 and 13. Moreover, the sealing resin 39 has a convex portion 39p that protrudes in the lateral direction. The metal members 11 and 13 are provided such that side surfaces 11s and 13s thereof are exposed on the top surface side and the bottom surface side of semiconductor module 7, respectively.

The gate terminal 57 is disposed in the vicinity of the gate electrode 15g in the sealing resin 39, and has a first portion 57a to be wire-connected thereto and a second portion 57b extending in the X direction and drawn out from the sealing resin 39.

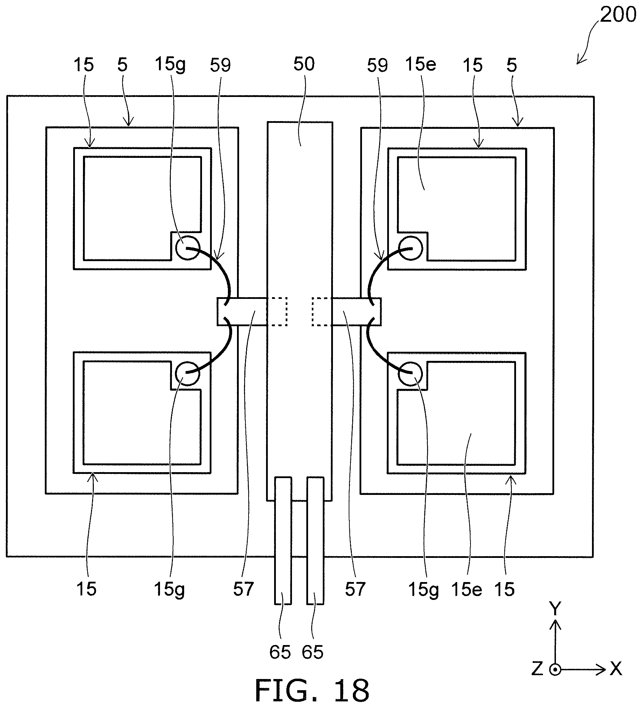

FIG. 18 is a schematic plan view illustrating the electrical connection between the semiconductor element 15 and the signal line 50 in the semiconductor device 200. As shown in FIG. 18, two semiconductor elements 15 are disposed such that two gate terminals 57 are opposite to each other. The two gate terminals 57 are electrically connected to the signal line 50. Moreover, the signal line 50 includes connection terminals 65 protruding toward the outside of the case 30 (see FIG. 13).

In the case where the gate electrode 15g is provided at a corner of the chip, it is possible to arrange four gate electrodes 15g close to each other as shown in FIG. 18. Then, the two gate terminals 57 can also be arranged close to each other. Thereby, it becomes easy to connect the signal line 50 and the gate terminal 57. Moreover, the manufacturing cost can be reduced by reducing the number of signal lines 50.

Furthermore, it is preferable that the metal wires 59 connecting the gate electrode 15g and the gate terminal 57 have substantially the same length. Thereby, it is possible to equalize the impedance of the signal line 50 that is electrically connected to each semiconductor element 15.

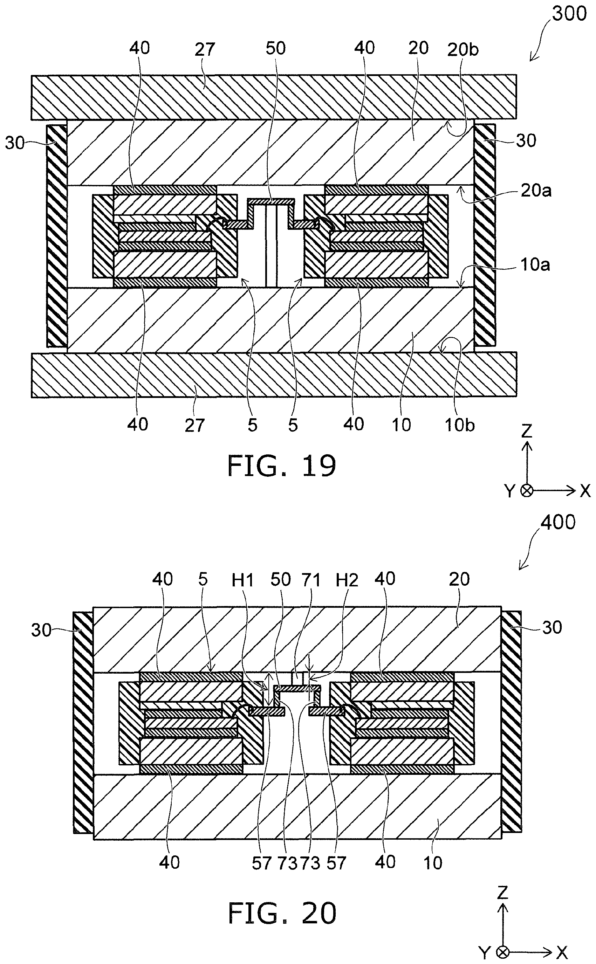

FIG. 19 is a perspective view schematically showing a semiconductor device 300 according to a first variation of the second embodiment. As shown in FIG. 19, the semiconductor device 300 has heat sinks 27 connected to the metal plates 10 and 20, respectively.

The heat sinks 27 are bonded to the major surfaces 10b and 20b of the metal plate 10 and the metal plate 20, respectively, by soldering or brazing, or friction stir welding, for example. The heat sinks 27 are electrically and thermally connected to the metal plates 10 and 20, and material superior in the thermal conductivity and electrical conductivity such as copper or aluminum is used therefor. Moreover, a heat sink 27 may be, for example, a water-cooled type cooler in which pure water is circulated.

In this example, the heat sinks 27 are bonded to the metal plates 10 and 20 without insulating substrates. Thus, the thermal resistance can be reduced in the heat radiation paths from the semiconductor element 15 to the heat sinks 27. Moreover, it is possible to avoid electrical leakage by using pure water as the coolant, which is electrically non-conductive.

FIG. 20 is a schematic cross-sectional view showing a semiconductor device 400 according to a second variation of the second embodiment. The semiconductor device 400 includes metal plates 10 and 20 and at least two semiconductor modules 5 disposed therebetween. Furthermore, between the metal plates 10 and 20, the semiconductor device 400 includes the signal line 50 provided between the semiconductor modules 5 adjacent to each other. The signal line 50 is electrically connected to the gate terminals 57 of the semiconductor modules 5 via the connection conductors 73.

As shown in FIG. 20, the signal line 50 is held by a protruding support 71 provided on the metal plate 20. The support 71 is an insulator made of epoxy resin, for example. The connection conductors 73 are fixed to the gate terminals 57 using a method, for example, soldering and like. The connection conductors 73 are, for example, elastic members, and are compressed between the signal line 50 and the gate terminals 57, and thereby, the connection conductors 73 are biased in the Z direction, for example. A connection conductor 73 has, for example, a spring structure such as a plunger and like.

Expressing the distance between the gate terminal 57 and the metal plate 20 as $H_1$, the height of the support 71 as $H_2$, and the thickness of the signal line 50 in the Z direction as $T_S$, the connection conductor 73 in the non-compressed state has the length $L_S$ that satisfies the following relationship.

$$H_1 < H_2 + T_S + L_S$$

Thereby, the electrical connection is secured between the signal line 50 and the gate terminal 57 via the connection conductor 73. At a position where the connection conductor 73 contacts the signal line 50, a structure such as a recess or the like is provided in the signal line 50 to prevent the connection conductor 73 from the positional shift.

In this example, a conductive elastic member is used to ensure the electrical connection between the signal line 50 and the gate terminal 57. Thereby, it is possible to achieve the simple and low-cost connection structure by reducing the process step such as soldering. The embodiment is not limited to the above example. For example, elastic material may be used for the signal line 50 or the gate terminal 57.

Furthermore, in place of the signal line 50, for example, a circuit board can be used, which includes the gate interconnection. Another circuit board may be used, which includes an interconnection electrically connecting the metal plate 20 and the emitter sense circuit in addition to the gate interconnection. For example, a conductive material is used for the support 71 to electrically connect the metal plate 20 and the emitter sense circuit. Thereby, it is possible to integrally configure the emitter sense circuit and the gate control circuit used for driving the semiconductor device 400, and thus, the cost reduction is achieved by reducing the process steps of incorporating the circuit boards.

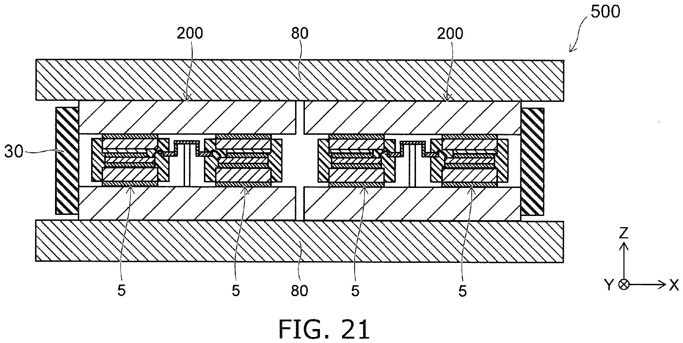

FIG. 21 is a schematic cross-sectional view showing a semiconductor device 500 according to a third embodiment. As shown in FIG. 21, the semiconductor device 500 has a structure in which at least two semiconductor devices 200 are disposed between two heat sinks 80. In this case, the case 30 is provided so as to surround the entire side surface of the semiconductor device 500.

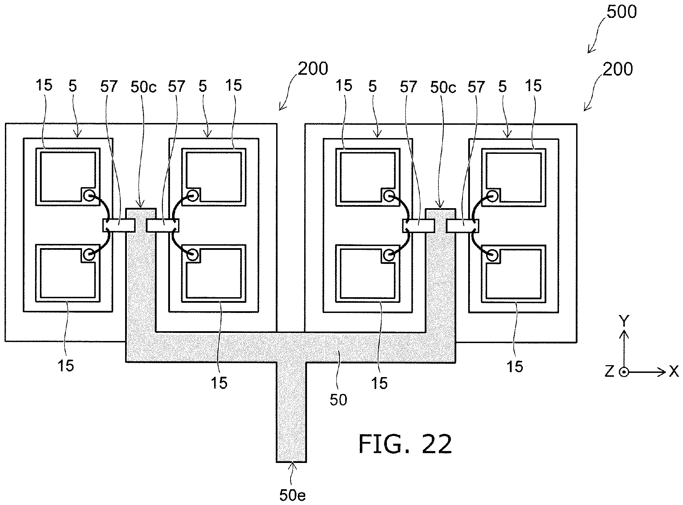

FIG. 22 is a schematic plan view showing the signal line 50 of the semiconductor device 500. As shown in FIG. 22, the signal line 50 includes one terminal portion 50e electrically connected to the gate electrodes 15g of the plurality of semiconductor elements 15, and connection portions 50c each connected to the gate terminals 57.

The terminal portion 50e extends outside from the semiconductor device 500, and is electrically connected, for example, to a gate control circuit. In the embodiment, the signal line 50 is provided such that the distances from the terminal portions 50e to the connection portions 50c are equal. Thereby, it is possible to make the impedance between the signal line 50 and each terminal portion 50e substantially the same. Thereby, the operation speed of each semiconductor element 15 can be made equivalent, and the electric current can flow uniformly. Thus, the current capacity can be increased in the semiconductor device 500.

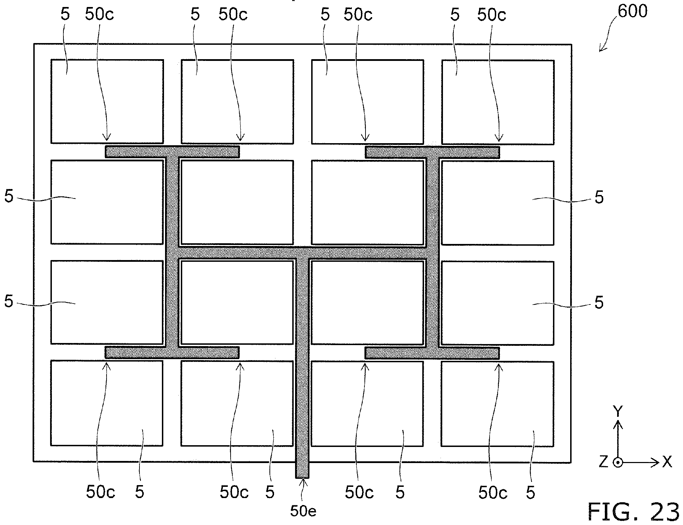

FIG. 23 is a schematic plan view showing another semiconductor device 600 according to the third embodiment. As shown in FIG. 23, the semiconductor device 600 includes a plurality of semiconductor modules 5 arranged in a 4 × 4 matrix. Also in this example, the signal line 50 includes connection portions 50c connected to each gate terminal 57 and one terminal portion 50e. The distances from the terminal portion 50e to the connection portions 50c are substantially the same. Thereby, the impedance between the signal line 50 and each of the terminal portions 50e can be made equivalent.

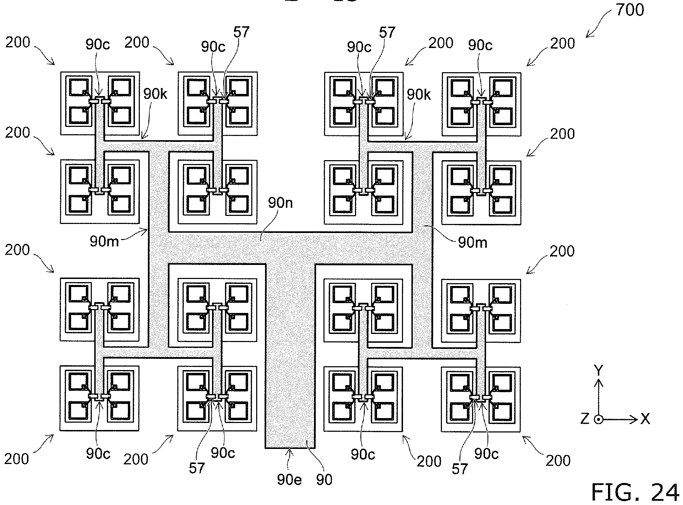

FIG. 24 is a schematic plan view showing a semiconductor device 700 according to a variation of the third embodiment. As shown in FIG. 24, the semiconductor device 700 includes a plurality of semiconductor devices 200 arranged in a $4 \times 4$ matrix. The signal line 90 includes a connection portion 90c connected to the gate terminals 57 of each semiconductor device 200 and one terminal portion 90e. The signal lines 90 are provided such that the lengths from the terminal portions 90e to the connection portions 90c are substantially the same.

Moreover, the signal line 90 includes common portions 90k, 90m and 90n linked to two or more connection portions 90c. For example, the common portion 90k is connected to two connection portions 90c, and the common portion 90m is connected to four connection portions 90c via the two common portions 90k. In other words, the electric current flowing in the common portion 90k is twice as large as the control current flowing into each connection portion 90c. Further, the electric current flowing in the common part 90m is four times the control current. For example, the width of the common portion 90k is twice the width of the connection portion 90c, and the width of the common portion 90m is four times the width of the connection portion 90c.

In this example, the width of each common portion is changed depending on the magnitude of the control current flowing therethrough. Thereby, the control current flowing into each connecting portion 90c from the terminal portion 90e can be made equivalent. The embodiment is not limited to this example. The thickness of the signal line 90 may be changed, for example, depending on the control current. Also, the cross-sectional area of the signal line 90 may be changed depending on the magnitude of the control current.

(Fourth Embodiment)

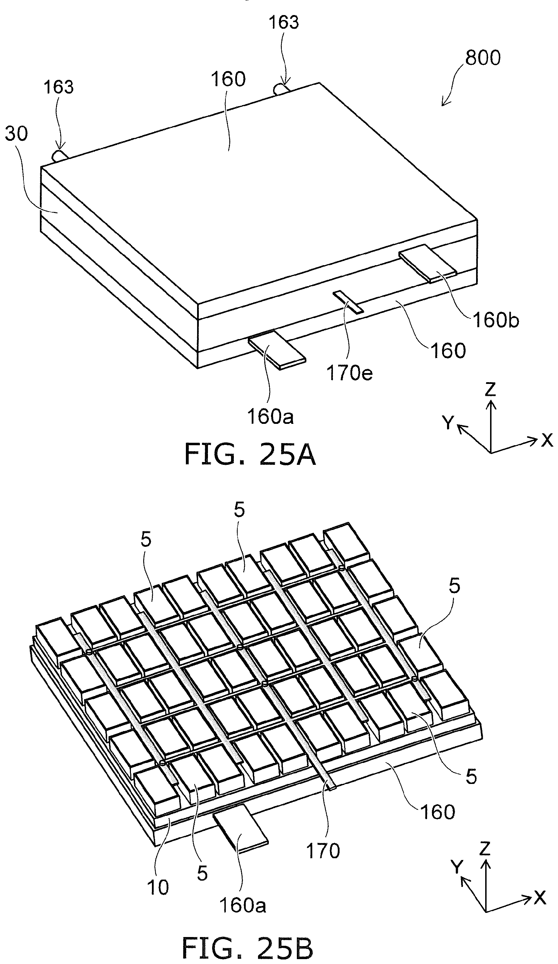

FIGS. 25A and 25B are schematic views showing a semiconductor device 800 according to a fourth embodiment. FIG. 25A is a perspective view showing the appearance of the semiconductor device 800, and FIG. 25B is a perspective view showing the arrangement of the semiconductor module 5.

As shown in FIG. 25A, the semiconductor device 800 has two heat sinks 160 arranged in an overlapping manner, and a case 30 disposed therebetween. The two heat sinks 160 are provided with connection terminals 160a and 160b, respectively. The connection terminals 160a and 160b protrude in the lateral direction. Further, the terminal portion 170e of a gate substrate 170 protrudes laterally from the case 30. Moreover, the heat sinks 160 are provided with connection portions 163 for water cooling.

As shown in FIG. 25B, a metal plate 10 is placed on the heat sink 160, and the plurality of semiconductor modules 5 are mounted on the metal plate 10. The semiconductor modules 5 are arranged, for example, in a 10 $\times$ 5 matrix. Then, the gate substrate 170 is provided so as to extend between the adjacent semiconductor modules 5. The gate substrate 170 includes, for example, an interconnection printed on an insulating substrate.

For example, the signal line 50 is mounted on the gate substrate 170. A signal line made of a thin metal plate or the like is easily deformed, for example, and the inductance thereof is slightly changed. In contrast, in the embodiment, it is possible to maintain the certain impedance by mounting the signal line 50 on a substrate that is hard to be deformed.

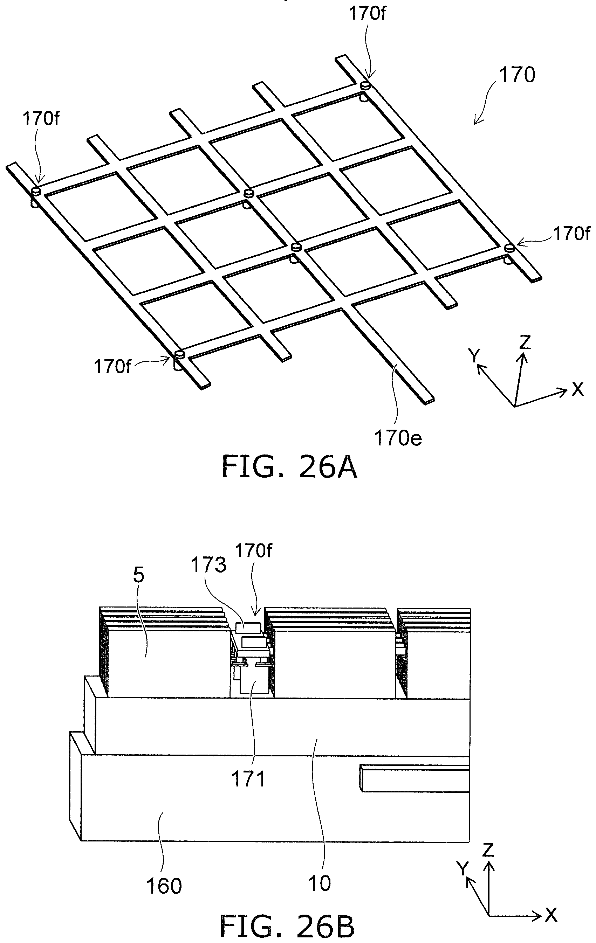

FIGS. 26A and 26B are schematic views showing parts of the semiconductor device 800. FIG. 26A is a perspective view schematically showing the gate substrate 170. FIG. 26B is a perspective view schematically showing the fixing portion 170f of the gate substrate 170.

As shown in FIG. 26A, the gate substrate 170 is provided in a lattice shape. The gate substrate 170 is sized, for example, so as to have openings capable of accommodating two semiconductor modules 5 between the lattices (see FIG. 26B). The semiconductor module 5 can be disposed so that the gate terminals 57 are opposite to each other, thereby reducing the connection portions of the gate substrate 170 and the gate terminals 57. Thus, it is possible to efficiently implement the connections of the gate substrate 170 and the gate terminals 57.

The gate substrate 170 has a plurality of fixing portions 170f, and is screwed to the metal plate 10 at each fixing portion 170f. As shown in FIG. 26B, the gate substrate 170 is fixed on the insulating spacer 171 using a screw 173. The embodiment is not limited to this example. For example, the gate substrate 170 may be fixed to the metal plate 20.

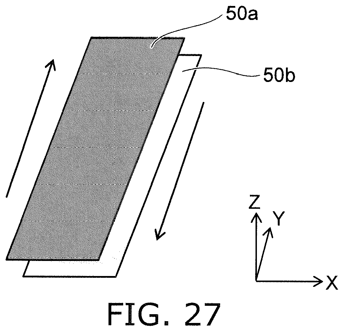

FIG. 27 is a perspective view schematically showing the signal lines 50a and 50b of the semiconductor device 800 according to the fourth embodiment. The signal lines 50a and 50b are mounted, for example, on the gate substrate 170.

The signal line 50a, for example, is electrically connected to the gate terminal 57. The signal line 50b, for example, is electrically connected to the emitter electrode 15e of the semiconductor element 15. That is, the signal line 50a is a forward interconnection directed from the terminal portion 170e of the gate substrate 170 to the connection portion with the gate terminal 57. The signal line 50b is a return interconnection directed from the emitter electrode 15e to the terminal portion 170e.

As shown in FIG. 27, the signal lines 50a and 50b are arranged in an overlapping manner. For example, an insulating layer such as a silicon oxide layer is provided between the signal line 50a and the signal line 50b. Thus, by arranging the forward interconnection and the return interconnection close to each other, the mutual inductance thereof contributes to the reduction of the parasitic inductance of the interconnections. When the parasitic inductance of the signal line is large, the semiconductor element 15 easily causes a malfunction due to noise. According to the embodiment, by reducing the parastic inductance, it is possible to prevent the semiconductor element 15 from malfunctioning, thus providing the stable operation.

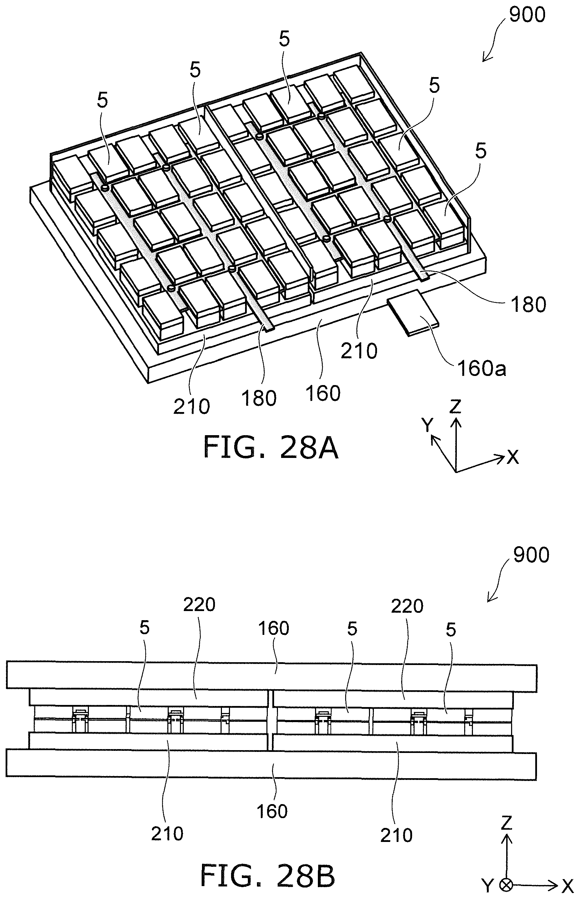

FIGS. 28A and 28B are views showing a semiconductor device 900 according to a first variation of the fourth embodiment. FIG. 28A is a perspective view showing the semiconductor device 900, and FIG. 28B is a cross-sectional view of the semiconductor device 900.

As shown in FIG. 28A, the semiconductor device 900 includes two metal plates 210 disposed on the heat sink 160, and a plurality of semiconductor modules 5 mounted on each metal plate 210. The semiconductor modules 5 are arranged in a 5 × 5 matrix on the metal plate 210. Moreover, the gate substrates 180 are also disposed on the metal plates 210, respectively. This example has an aspect such that the metal plate 10 of the semiconductor device 800 shown in FIG. 25 is divided, and the semiconductor module 5 and the gate substrate 180 are disposed thereon, respectively.

As shown in FIG. 28B, the semiconductor device 900 includes the metal plates 210, metal plates 220 and the plurality of semiconductor modules 5 between the heat sinks 160 arranged vertically. The semiconductor modules 5 are disposed between a metal plate 210 and a metal plate 220.

For example, as the number of semiconductor modules 5 increases, the size of the metal plate is enlarged for mounting the semiconductor modules 5. When the semiconductor modules are mounted in parallel between the metal plates, there may be a connection failure between the semiconductor modules and the metal plate due to the height variations of the top surfaces of the semiconductor modules 5 depending on the flatness of the surface of the metal plate. Thus, the manufacturing cost may be increased when making the metal plate have the surface of high flatness. In this example, by dividing the metal plate, it is possible to avoid the enlargement thereof and to ensure the predetermined flatness. Thereby, it is possible to improve the manufacturing yield of the semiconductor device 900, while achieving the large current capacity. Moreover, by arranging the gate substrate 180 for each metal plate, it is possible to mount the metal plates 210 and 220 as one unit that includes the semiconductor module 5 and the gate substrate 180 arranged therebetween, thus improving the manufacturing efficiency.

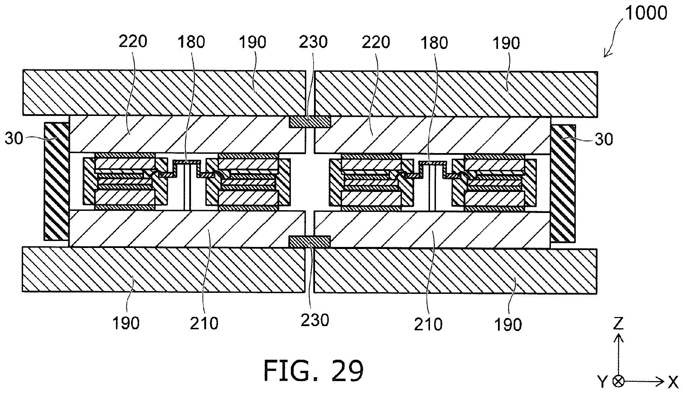

FIG. 29 is a schematic cross-sectional view showing a semiconductor device 1000 according to a second variation of the fourth embodiment. As shown in FIG. 29, the semiconductor device 1000 includes heat sinks 190 each bonded to the metal plate 210 or 220.

This example has an aspect such that the heat sinks 160 are also divided in the semiconductor device 900 shown in FIGS. 28A and 28B. Thereby, it is possible to make the bonding of the heat sink 190 and the metal plate 210 or 220 easier by improving the flatness of the bonding surface of the heat sink 190, thus reducing the thermal resistance between the heat sink 190 and the metal plate 210 or 220.

Further, the semiconductor device 1000 includes connection conductors 230 for electrically connecting two adjacent metal plates. For example, in the semiconductor device 900, since the heat sink 160 is connected to both adjacent two metal plates, the adjacent two metal plates are electrically connected via the heat sink 160. In this example, the heat sink 190 is connected to each metal plate, and the connection conductors 230 each ensure the electrical connection between the metal plates. The connection conductor 230 may be provided between the adjacent heat sinks 160.

The first to fourth embodiments have been described above as examples, and the constituent elements of the respective embodiments are not unique thereto, and may be mutually applied if technically possible.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or variations as would fall within the scope and spirit of the invention.

[Description of Symbols]

1, 2, 3, 4, 5, 6, 7...Semiconductor module; 10, 20, 210, 220...Metal plate; 10a, 10b, 11m, 13m, 20a, 20b...Major surface; 11, 12...Metal member; 11s, 13s...Side surface; 13a, 57a...First portion; 13b, 57b...Second portion; 13r...Recess; 15...Semiconductor element; 15e...Emitter electrode; 15g...Gate electrode; 17, 40...Bonding member; 19, 31, 33, 35, 37, 39...Sealing resin; 21, 23, 27...Heat sink; 25...Heat radiating fin; 30...Case; 31p, 33p, 35p, 37p, 39p...Convex portion; 31q...Corner; 33r...Rceessed portion; 50, 50a, 50b, 90...Signal line; 50c, 90c...Connection portion; 50e, 90e, 170e...Terminal portion; 53, 171...Insulating spacer; 55, 73, 230...Connection conductor; 71...Support; 80, 160, 190...Heat sink; 90k, 90m, 90n...Common portion; 100, 110, 120, 130, 140, 150, 200, 300, 400, 500, 600, 700, 800, 900, 1000...Semiconductor device; 170, 180...Gate substrate; 163...Connection portion; 170f...Fixing portion; 173...Screw

**Claims**

1. A semiconductor device comprising:

    a first metal plate having a first surface;
    a second metal plate having a second surface facing the first surface; and

two or more semiconductor modules disposed between the first metal plate and the second metal plate,

the two or more semiconductor modules each including a first metal member electrically connected to the first metal plate, a second metal member electrically connected to the second metal plate, at least one semiconductor element disposed between the first metal member and the second metal member, and a resin member sealing the semiconductor element between the first metal member and the second metal member,

the at least one semiconductor element including a first electrode electrically connected to the first metal member, and a second electrode electrically connected to the second metal member.

2. The semiconductor device according to claim 1, wherein

the second metal member has a first portion and a second portion, the second portion being positioned between the semiconductor element and the first portion, the first portion having a cross-sectional area parallel to the second surface, the second portion having a cross-sectional area parallel to the second surface, and

the cross-sectional area of the first portion is larger than the cross-sectional area of the second portion.

3. The semiconductor device according to claim 1, wherein

the second metal member has a first portion and a second portion, the second portion being positioned between the semiconductor element and the first portion, and

the second portion has a shape that fits the second electrode.

4. The semiconductor device according to claim 1, wherein

the semiconductor module further includes a third metal member, and

the semiconductor element further includes a third electrode electrically connected to the third metal member between the first metal member and the second metal member.

5. The semiconductor device according to claim 4, further comprising:

a first interconnection disposed between the two or more semiconductor modules and between the first metal plate and the second metal plate, the first interconnection being electrically connected to the third metal member; and

a first external terminal electrically connected to the first interconnection.

6. The semiconductor device according to claim 5, wherein the first interconnection is provided to have constant impedance between the first external terminal and the third metal member.

7. The semiconductor device according to claim 6, wherein the first interconnection has a constant length between the third metal member and the first external terminal.

8. The semiconductor device according to claim 6, wherein the interconnection has end portions each connected to the third electrode and a common portion having a cross section wider than the end portions.

9. The semiconductor device according to claim 5, further comprising:

a second interconnection disposed between the two or more semiconductor modules and between the first metal plate and the second metal plate, the second interconnection being electrically connected to the first electrode or the second electrode; and

a second external terminal electrically connected to the second interconnections.

10. The semiconductor device according to claim 5, wherein the first interconnection is electrically connected to the third metal member using an elastic member.

11. The semiconductor device according to claim 1, wherein the resin member has a convex portion protruding in a direction along the first surface of the first metal plate or a concave portion being receded in a direction along the first surface.

12. The semiconductor device according to claim 1, wherein the resin member protrudes in a direction along the first surface of the first metal plate and has a chamfered end portion.

13. The semiconductor device according to claim 1, further comprising:

first bonding members disposed between the semiconductor element and the first metal member, and between the semiconductor element and the second metal member; and

second bonding members disposed between the first metal member and the first metal plate, and between the second metal member and the second metal plate,

the first bonding members having a melting point higher than a melting point of the second bonding member.

14. The semiconductor device according to claim 1, further comprising:

    a first heat sink connected to the first metal plate; and
    a second heat sink connected to the second metal plate.

15. The semiconductor device according to claim 14, wherein at least one of the first heat sink and the second heat sink includes a plurality of parts divided.

16. The semiconductor device according to claim 15, wherein the plurality of parts divided are electrically connected via the first metal plate or the second metal plate.

17. The semiconductor device according to claim 14, wherein at least one of the first metal plate and the second metal plate includes a plurality of parts divided.

18. The semiconductor device according to claim 17, wherein the plurality of parts divided are electrically connected via the first heat sink or the second heat sink.

19. The semiconductor device according to claim 15, further comprising:

    a first heat sink connected to the first metal plate; and
    a second heat sink connected to the second metal plate,
    the plurality of parts divided are electrically connected via the first heat sink or the second heat sink.

20. The semiconductor device according to claim 14, wherein
    at least one of the first heat sink and the second heat sink includes first and second parts divided, the first part being positioned between the first metal plate or the second metal plate and the second portion, and
    the first part is in contact with the first metal plate or the second metal plate.

21. The semiconductor device according to claim 1, further comprising:
    a plurality of fins connected to at least one of the first metal plate and the second metal plate.

22. The semiconductor device according to claim 21, wherein at least one of the first metal plate and the second metal plate has a plurality of parts divided.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14A

FIG. 14B

FIG. 15A

FIG. 15B

FIG. 16

FIG. 17A

FIG. 17B

200

15  5  15g  59  50  59  15e  15  5

15  15g  57  57  15g 15e 15

65 65

Y
↑
Z ⊙ → X

FIG. 18

FIG. 19

FIG. 20

FIG. 21

FIG. 22

FIG. 23

FIG. 24

FIG. 25A

FIG. 25B

170f

170f

170

170f

170f

170e

FIG. 26A

5    173    170f

160    171    10

FIG. 26B

50a

50b

Z
Y
X

FIG. 27

900

5

5

5

5

5

5

180

210

210    180    160

210

160a

## FIG. 28A

Y    Z

X

900

5    220    160    5    220    5

210    160    210

## FIG. 28B

Z

Y    X

FIG. 29

# EP 3 584 834 A1

<table>
<tr><td colspan="2" align="center"><strong>INTERNATIONAL SEARCH REPORT</strong></td><td>International application No.<br>PCT/JP2018/004428</td></tr>
</table>

**A. CLASSIFICATION OF SUBJECT MATTER**
Int.Cl. H01L25/07(2006.01)i, H01L23/29(2006.01)i, H01L25/18(2006.01)i

According to International Patent Classification (IPC) or to both national classification and IPC

**B. FIELDS SEARCHED**

Minimum documentation searched (classification system followed by classification symbols)
Int.Cl. H01L25/07, H01L23/29, H01L25/18

Documentation searched other than minimum documentation to the extent that such documents are included in the fields searched

| | |
|---|---|
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2010-225720 A (MITSUBISHI ELECTRIC CORP.) 07 October 2010, paragraphs [0013]-[0019], fig. 1 & US 2010/0238627 A1, paragraphs [0022]-[0028], fig. 1 & DE 102009040444 A & CN 101847620 A & KR 10-2010-0106189 A | 1, 4, 21<br>2-3, 5-20, 22 |
| Y | JP 2013-084706 A (TOYOTA MOTOR CORP.) 09 May 2013, paragraphs [0027]-[0032], fig. 1-2 (Family: none) | 2-3 |
| Y | JP 2009-165278 A (MEIDENSHA CORP.) 23 July 2009, paragraphs [0002]-[0005], [0011]-[0013], fig. 1, 4 (Family: none) | 5-10 |

☒ Further documents are listed in the continuation of Box C. ☐ See patent family annex.

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>    30 March 2018 (30.03.2018) | Date of mailing of the international search report<br>    10 April 2018 (10.04.2018) |
|---|---|
| Name and mailing address of the ISA/<br>    Japan Patent Office<br>    3-4-3, Kasumigaseki, Chiyoda-ku,<br>    Tokyo 100-8915, Japan | Authorized officer<br><br>Telephone No. |

Form PCT/ISA/210 (second sheet) (January 2015)

**INTERNATIONAL SEARCH REPORT**

| International application No. |
| --- |
| PCT/JP2018/004428 |

**C (Continuation).   DOCUMENTS CONSIDERED TO BE RELEVANT**

| Category* | Citation of document, with indication, where appropriate, of the relevant passages | Relevant to claim No. |
| --- | --- | --- |
| Y | JP 2001-102520 A (TOSHIBA CORP.) 13 April 2001, paragraphs [0002], [0026], fig. 3 (Family: none) | 5-10 |
| Y | JP 2016-072354 A (TOYOTA MOTOR CORP.) 09 May 2016, paragraphs [0012]-[0036], fig. 1-4 (Family: none) | 11-12 |
| Y | JP 2007-251076 A (HITACHI, LTD.) 27 September 2007, paragraph [0009], fig. 1 & US 2007/0216013 A1, paragraph [0017], fig. 1 & DE 102007004005 A | 13 |
| Y | JP 2006-237060 A (NEC CORP.) 07 September 2006, paragraphs [0018]-[0019], fig. 1-2 & US 2006/0185896 A1, paragraphs [0033]-[0035], fig. 1-2 & CN 1825575 A & TW 200631145 A | 14-16, 19 |
| Y | JP 2013-009501 A (HITACHI AUTOMOTIVE SYSTEMS, LTD.) 10 January 2013, paragraph [0047] & US 2014/0118934 A1, paragraph [0055] & EP 2725699 A1 & CN 103650318 A | 17-18, 22 |
| Y | JP 2003-124410 A (YAMAHA CORP.) 25 April 2003, paragraph [0016], fig. 1 (Family: none) | 20 |
| Y | US 2014/0185243 A1 (HYUNDAI MOTOR COMPANY) 03 July 2014, paragraphs [0040]-[0046], fig. 7-8 & KR 10-2014-0084590 A & CN 103904911 A | 1-22 |
| A | JP 2009-283656 A (DENSO CORP.) 03 December 2009, fig. 2 & US 2009/0289351 A1, fig. 2 & DE 102009022221 A | 1-22 |

Form PCT/ISA/210 (continuation of second sheet) (January 2015)

**EP 3 584 834 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H8330338 B
- JP 2006013080 A